# EUROPÄISCHE PATENTSCHRIFT

(11) **EP 1 919 035 B1**
(45) Veröffentlichungstag und Bekanntmachung des Hinweises auf die Patenterteilung: **16.03.2011**
(21) Anmeldenummer: 07119085.4
(22) Anmeldetag: 23.10.2007
(51) Int. Cl.: H01R 12/57, H01R 9/24

(54) **Leistungselektronikschaltung sowie Leistungselektronikvorrichtung mit einer Leistungselektronikschaltung**
Power electronics connection and power electronics device with a power electronics circuit
Commutation électronique de puissance ainsi que dispositif électronique de puissance doté d'un circuit électronique de puissance

(30) Priorität: 06.11.2006 DE 102006052118
(43) Veröffentlichungstag der Anmeldung: 07.05.2008
(73) Patentinhaber: ROBERT BOSCH GMBH, 70442 Stuttgart (DE)
(72) Erfinder: Voigtlaender, Klaus, 73117 Wangen (DE)

(56) Entgegenhaltungen:
- EP-A- 0 472 006
- DE-A1- 10 249 683
- US-A- 6 011 319
- US-A- 6 062 916
- US-A1- 2005 111 798

## Beschreibung

### Stand der Technik

Die Erfindung betrifft eine Leistungselektronikschaltung, die auf einem Substrat angeordnet und an mindestens eine elektrische, hochstrombelastbare Verbindung insbesondere direkt angeschlossen ist.

Es ist bekannt, Leiterplatten mit IMS-Substraten (Insulated Metal Substrate) über Stanzgitter zu verbinden. Soll daran beispielsweise eine Elektromotor angeschlossen werden, der von einer elektronischen Schaltung auf der Leiterplatte/ dem Substrat versorgt wird, so ergeben sich eine Vielzahl von elektrischen Übergängen: IMS/Stanzgitter, Stanzgitter/Leiterplatte, Leiterplatte/Stecker, Stecker/Kabel, Kabel/Motor, was zu relativ hohen elektrischen Verlusten führt.

US 6011319 beschreibt die Verbindung einer Leistungselektronik mit einer Steuerelektronik. Dabei wird die Verbindung über eine Flachbandverbindung in Form eines eben ausgebildeten Blechstanzteiles hergestellt Dieses ist mit einem Ende in das Substrat der Leistungselektronik gesteckt und mit diesem verlötet. Das andere Ende weist ein Schneidklemmverbindungselement auf, über welches dann über Fügen eine Verbindung zu einem Gegenelement der Steuerelektronik erfolgt. Das Ende mit dem Schneidklemmverbindungselement weist zusätzlich eine Stützschulter auf. Diese ist als ein Anschlag ausgebildet, welcher die Positionierung der Flachbandverbindung beim Einstecken und Verlöten in dem Substrat der Leistungselektronik festlegt. Beim Fügen des Gegenelementes werden Fügekräfte über die Stützschulter in das Substrat eingeleitet.

### Offenbarung der Erfindung

Aufgrund der erfindungsgemäßen Ausbildung, bei der eine Verbindung als Flachband-Verbindung ausgebildet ist, die im Bereich ihres freien Endes ein Schneidklemmverbindungselement und mindestens eine Stützschulter zur Aufnahme einer Zusammenfügkraft beim Verbinden mit einem Gegenelement aufweist, ist ein hochstrombelastbarer, einfacher Verbindungsweg geschaffen. Die Hochstromverbindung führt von dem Substrat, mit dem sie vorzugsweise direkt verbunden ist, über das Schneidklemmverbindungselement zu einem mit letzterem durch Zusammenfügkraft verbundenen Gegenelement, wobei der beschriebene Verbindungsweg als Flachband-Verbindung ausgebildet ist, die einstückig ausgestaltet ist, sodass nur eine Verbindungsstelle mit dem Schneidklemmverbindungselement vorliegt. Um das Schneidklemmverbindungselement mit einem entsprechenden Gegenelement zu verbinden, muss eine Zusammenfügkraft aufgebracht werden, die von der mindestens einen Stützschulter abgefangen wird, sodass keine unzulässigen Kräfte beim mechanischen Verbinden in das Substrat eingeleitet werden. Es liegt demgemäß eine sehr niederomige Verbindung vor, die überdies hochstrombelastbar ist (beispielsweise für 50-150 Ampere) und einfach und problemlos gehandhabt werden kann.

Nach einer Weiterbildung der Erfindung ist vorgesehen, dass die Flachband-Verbindung als Metallstreifen, insbesondere Blechstanzteil, ausgebildet ist. Ein derartiger Metallstreifen ist hochstromfest und sehr einfach einstückig insbesondere als Blechstanzteil herstellbar.

Ferner ist es vorteilhaft, mindestens zwei, einander gegenüberliegende Stützschultern vorzusehen. Die Flachband-Verbindung stützt sich beim Zusammenfügen mit dem Gegenelement an den beiden Stützschultern ab, wodurch hohe Zusammenfügekräfte problemlos aufgebracht werden können, ohne dass es zu unzulässigen Krafteinleitungen kommt.

Ferner ist es vorteilhaft, wenn der direkte Anschluss der Verbindung an dem Substrat als Löt-, Schweiß- und/oder Nietverbindung ausgebildet ist.

Eine Weiterbildung der Erfindung sieht vor, dass die Flachband-Verbindung in Richtung ihrer Längserstreckung durch die Ausbildung mindestens einer Biegestelle verformbar ist. Demzufolge liegt beim Zusammenfügen mit dem Gegenelement eine gewisse Verformbarkeit vor, sodass Toleranzen ausgeglichen werden können. Die Biegestelle ist bevorzugt als U-Steg ausgebildet. Dies bedeutet, dass die Flachband-Verbindung bis zur Biegestelle verläuft, dort aus ihrer Längserstreckung in die U-Form des U-Stegs übergeht und von dort wiederum in die ursprüngliche Längserstreckungsrichtung. Der U-Steg weist im Wesentlichen einen quadratischen Querschnitt auf, sodass eine gute Verformbarkeit besteht, die hinsichtlich des sonst im Wesentlichen vorzugsweise rechteckigen, insbesondere lang-rechteckigen Querschnitts der Flachband-Verbindung nicht gegeben ist.

Ferner ist es vorteilhaft, wenn das Schneidklemmverbindungselement als Einsteckschlitz für einen Einstecksteg des Gegenelements oder als Einstecksteg für einen Einsteckschlitz des Gegenelements ausgebildet ist.

Ferner betrifft die Erfindung eine Leistungselektronikvorrichtung mit einer Leistungselektronikschaltung, insbesondere wie vorstehend beschrieben, wobei eine mit der Flachband-Verbindung durch Zusammenfügen elektrisch verbundene Gegen-Flachband-Verbindung vorgesehen ist.

Diese Gegen-Flachband-Verbindung ist bevorzugt als Gegenelement ausgebildet oder weist dieses auf.

Ferner ist vorgesehen, dass die Gegen-Flachband-Verbindung als Metallstreifen, insbesondere Blechstanzteil, ausgebildet ist. Demzufolge ist der grundsätzliche Aufbau von Flachband-Verbindung und Gegen-Flachbandverbindung sehr ähnlich. Unterschiedlich sind lediglich die Verbindungselemente, um die Teile zusammenfügen zu können. Diese Verbindungselemente müssen einander entsprechend ausgebildet sein, um durch Zusammenfügen, insbesondere Zusammenstecken, eine elektrisch haltbare Verbindung zu schaffen. Vorzugsweise ist vorgesehen, dass diese elektrische Verbindung als nach dem Zusammenfügen unlösbare Verbindung ausgebildet ist. Die Unlösbarkeit resultiert daraus, dass beim Zusammenfügen eine entsprechende Materialverformung stattfindet.

Nach einer Weiterbildung der Erfindung ist vorgesehen, dass die Leistungselektronikvorrichtung einen elektrisch nicht leitenden Lagerkanal aufweist, in den die Flachband-Verbindung derart eingelegt ist, dass sie sich mit ihrer mindestens einen Stützschulter, vorzugsweise mit beiden Stützschultern, an den Kanalrändern abstützt. Demzufolge ist die Flachband-Verbindung in Längsrichtung des Kanals verschiebbar, jedoch quer dazu abgestützt, sodass das Gegenelement mit einer entsprechenden Zusammenfügekraft zum elektrischen Verbinden zugeführt werden kann.

Vorzugsweise ist vorgesehen, dass nach Fertigstellung des Zusammenfügens von Flachband-Verbindung und Gegen-Flachband-Verbindung ein hermetisches Verschließen erfolgt, sodass dann auch keine optische Kontrolle mehr möglich ist. Das hermetische Verschließen kann beispielsweise durch Einbringen in ein Gehäuse, Eingießen und/oder Umspritzen mit einem elektrischen nicht leitenden Material erfolgen.

Durch die direkte Anbindung der Schneidklemmverbindungselemente bzw. der Gegenelemente auf einem IMS- oder DBS (Direct Bonded Copper) -Substrat kann eine bauraumoptimierte Leistungselektronikvorrichtung mit einem sehr geringen thermischen Widerstand geschaffen werden, wodurch die Elektronikkomponenten und die hochstrombelastete Verbindung höhere Leistungen aufnehmen können.

### Kurze Beschreibung der Zeichnungen

Die Zeichnungen veranschaulichen die Erfindung anhand eines Ausführungsbeispiels und zwar zeigt:
- Figur 1: eine Leistungselektronikschaltung, die mit einer Flachband-Verbindung versehen ist,
- Figur 2: wiederum eine Leistungselektronikschaltung, die ebenfalls eine Flachband-Verbindung aufweist, wobei jedoch gegenüber Figur 1 ein anderes Verbindungselement vorliegt,
- Figur 3: ein Gegenelement, das mit der Flachband-Verbindung der Figur 1 gekoppelt werden kann und
- Figur 4: eine Flachband-Verbindung, die mit einer Gegen-Flachband-Verbindung gekoppelt ist.

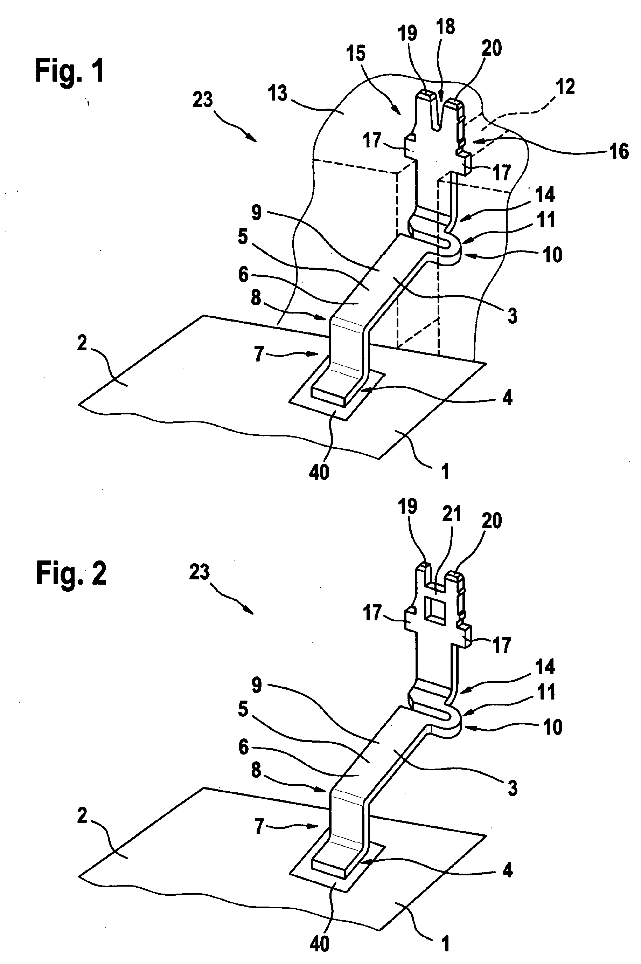

Die Figur 1 zeigt ein Substrat 1, das als Leiterplatte 2 ausgebildet ist. Auf der Leiterplatte 2 befindet sich eine Leistungselektronik, die der Einfachheit halber nicht dargestellt ist. An der Leiterplatte 2, also an einer Kontaktfläche 40, die mit der Leistungselektronik verbunden ist, ist eine elektrische, hochstrombelastbare Verbindung 3 angeschlossen, wobei die Anschlussstelle 4 als Löt-, Schweiß- und/oder Nietverbindung ausgebildet sein kann. Die Anschlussstelle 4 ist als direkte Anschlussstelle 4 ausgebildet, das heißt, die Verbindung 3 ist direkt mit der erwähnten Kontaktfläche 40 verbunden.

Die Verbindung 3 ist als Flachband-Verbindung 5 ausgebildet. Sie besteht aus einem elektrisch leitfähigen Metallstreifen 6, der im Wesentlichen einem rechteckigen Querschnitt aufweist. Der eine Endbereich 7 ist mit Kröpfung 8 versehen. An die Kröpfung 8 schließt sich ein geradlinig verlaufender Bereich 9 an, der in eine Biegestelle 10 übergeht. Die Biegestelle 10 überragt den Metallstreifen 6 seitlich und weist einen etwa quadratischen Querschnitt auf. Von der Breitseite des Bereichs 9 her betrachtet ist die Biegestelle 10 als U-Steg 11 ausgebildet. Bei einem nichtdargestellten Ausführungsbeispiel kann anstelle des U-Stegs auch ein mäanderförmiges Element vorgesehen sein.

Nach der Biegestelle 10 geht der Metallstreifen 6 wieder in seinen rechteckigen Flachbandquerschnitt über und taucht in einen Lagerkanal 12 ein, der in einem Stützelement 13 aus elektrisch nicht leitendem Material ausgebildet ist. Der Endbereich 7 ist innerhalb des Lagerkanals 12 nach oben hin abgebogen (Biegung 14) und verläuft bis zu einem Schneidklemmverbindungselement 15, das außerhalb des Lagerkanals 12 liegt. Das Schneidklemmverbindungselement 15 ist im Bereich eines freien Endes 16 der Flachband-Verbindung 5 ausgebildet. Dort befinden sich zwei aneinander gegenüberliegende Stützschultern 17 der Flachband-Verbindung 5, die einstückig mit dem Metallstreifen 6 ausgebildet sind und sich an den Kanalrändern des Lagerkanals 12 abstützen. Das Schneidklemmverbindungselement 15 weist einen Einsteckschlitz 18 auf, das heißt, endseitig ist die Flachband-Verbindung 5 gabelartig mit zwei Gabelzinken 19, 20 gestaltet.

Beim Ausführungsbeispiel der Figur 2 liegt-gegenüber der Figur 1-eine identische Ausbildung vor, sodass auf die vorstehende Beschreibung verwiesen wird. Unterschiedlich ist lediglich, dass kein Einsteckschlitz 18 vorhanden ist, sondern das anstelle von diesem ein Einstecksteg 21 ausgebildet ist. Der Einstecksteg 21 ist beidendig mit der übrigen Struktur des Metallstreifens 6 verbunden, das heißt, ein Ende des Einsteckstegs 19 steht mit der Gabelzinke 19 und das andere Ende mit der Gabelzinke 20 einstückig in Verbindung.

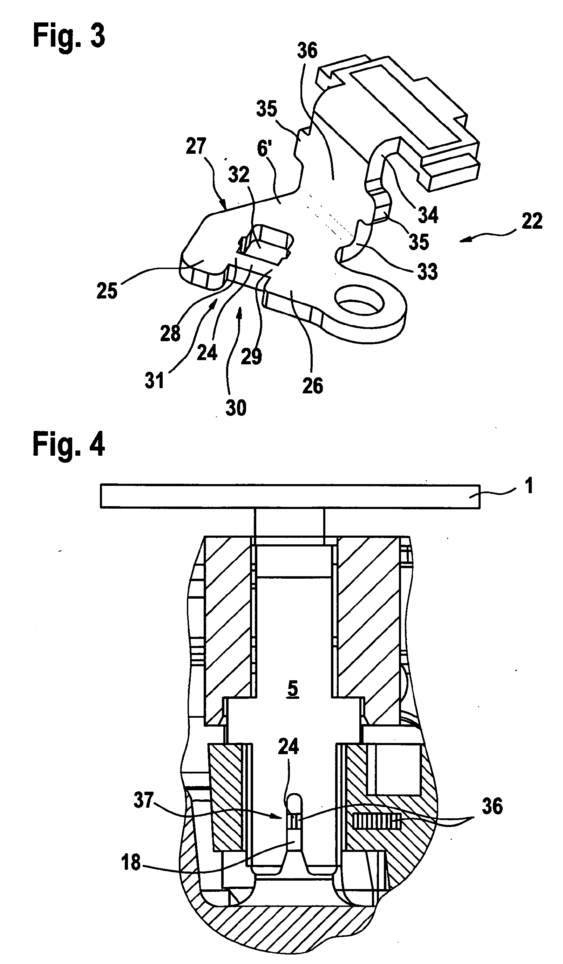

Die Figur 3 zeigt ein Gegenelement 22, das mit der hochstrombelastbaren Verbindung 3 der Figur 1 durch Zusammenstecken im Zuge eines Fügeprozesses elektrisch verbunden werden kann. Insbesondere erfolgt ein unlösbares Zusammenfügen der beiden Teile. Auch das Gegenelement 22 ist hochstrombelastbar. Insgesamt wird eine Schneidklemmverbindung 37 geschaffen. Das Gegenelement 22 gehört beispielsweise einem elektrischen Verbraucher, insbesondere einem Elektromotor an, wobei dieser Verbraucher/Elektromotor mit der in den Figuren 1 und 2 angedeuteten Leistungselektronikschaltung 23 elektrisch verbunden werden soll, das heißt, die Leistungselektronik auf dem Substrat 1 versorgt über die Flachbandverbindung 5 und das Gegenelement 22 den entsprechenden elektrischen Verbraucher.

Gemäß Figur 3 weist das Gegenelement 22 einen Einstecksteg 24 auf. Der Einstecksteg ist zwischen einer zwei Schenkel 25 und 26 aufweisenden Gabel 27 des Gegenelements 22 angeordnet, insbesondere einstückig am Gegenelement 22 realisiert. Die beiden Enden 28 und 29 des Einsteckstegs 24 sind einstückig an die Schenkel 25 und 26 angebunden. Da der Einstecksteg 24 eine randoffene Ausnehmung 30 überbrückt, grenzt an ihn eine Ausnehmung 31 sowie ein Durchbruch 32 an. Das Gegenelement 22 weist beispielsweise den aus der Figur 3 hervorgehenden gekröpften Verlauf mit zwei Abbiegungen 33 und 34 auf und ist mit Stützstegen 35 versehen. Mit dem Gegenelement 22 ist vorzugsweise direkt der elektrische Verbraucher, beispielsweise ein Elektromotor, elektrisch verbunden, sodass eine niederohmige, hochstrombelastbare Verbindung geschaffen ist.

Das Gegenelement 22 ist-ebenso wie die Flachbandverbindung 5-als Metallstreifen 6', insbesondere Blechstanzteil, ausgebildet. Das Gegenelement 22 stellt eine Gegen-Flachband-Verbindung 36 zum Zusammenfügen mit der Flachband-Verbindung 5 dar. Zum Zusammenfügen wird die Gegen-Flachband-Verbindung 36 mit ihrem Einstecksteg 24 zwischen die Gabelzinken 19 und 20 der Flachband-Verbindung 5 gedrückt, sodass der Einstecksteg 24 in den Einsteckschlitz 18 eindringt, wodurch ein Fügeprozess erfolgt und die hochstrombelastbare Verbindung geschaffen wird. Insbesondere ist vorgesehen, dass bei dem Fügeprozess eine Kraft-Wegkurve vom Fügeprozess aufgenommen wird. Beim Zusammenfügen liegen die Teile zunächst gegeneinander an. Hierbei ist der Einstecksteg 24 in den Einsteckschlitz 18 teilweise eingesteckt, wobei jedoch noch nicht die Endposition eingenommen ist. Durch Krafterhöhung tritt Gleitreibung ein, sodass die Fügekraft abfällt. Danach steigt die Fügekraft bis zum Endsitz wieder an. In dieser Phase wird eine erste Schneidklemmverbindung hergestellt, mit einer deutlichen Kraftspitze. Nach deren Abfall wird-sofern eine mehrpolige Verbindung zum Anschluss des Verbrauchers an die Leistungselektronik benötigt wird, eine zweite, entsprechend gleiche Verbindung hergestellt, dies ebenfalls mit einer deutlichen Kraftspitze. Auch hier erhöht sich die Kraft kontinuierlich bis zum Aufsitzen. Mit der erwähnten Kraftmessung kann also festgestellt werden, ob alle Verbindungen im Rahmen der vorgegebenen Toleranz liegen. Ist dies nicht der Fall, könnten Teile fehlen, Stecker verbogen sein oder Kontakte nicht hergestellt worden sein. Alternativ kann zusätzlich noch eine Presspassung gefügt werden, die zusätzlich bei der aufgenommenen Kraftmessung sichtbar sein muss, um eine Kontrolle zu haben. Beim Fügeprozess stützt sich die Flachbandverbindung 5-wie aus der Figur 1 ersichtlich-mit ihren Stützschultern 17 auf den Randseiten des Lagerkanals 12 ab, sodass keine schädlichen Kräfte in das Substrat 1 usw. eingeleitet werden. Aufgrund des Lagerkanals 12 ist in Längsrichtung des Kanals unter Stauchung oder Aufweitung der Biegestelle 10 eine Ausrichtungsveränderung der Flachband-Verbindung 5 möglich.

Beim Ausführungsbeispiel der Figur 2 ist ein Einstecksteg vorgesehen. Demgemäß weist ein zugehöriges Gegenelement 22 keinen Einstecksteg 24, sondern einen Einsteckschlitz 18 auf, sowie er aus der Figur 1 bei der Flachband-Verbindung 5 hervorgeht.

Die Figur 4 zeigt eine Flachbandverbindung 5 mit Einsteckschlitz 18, wobei die Flachband-Verbindung 5 mit dem Substrat 1 verbunden ist, das die Leistungselektronik aufweist. Die Flachband-Verbindung 5 ist mit einer Gegen-Flachband-Verbindung 36 zusammengeführt, wobei diese einen Einstecksteg 24 aufweist, der in den Einsteckschlitz 18 eingepresst ist, sodass eine Schneidklemmverbindung 37 geschaffen wurde. Die Gegen-Flachband-Verbindung 36 ist direkt mit einem in der Figur 4 nicht dargestellten elektrischen Verbraucher verbunden.

Aufgrund der Erfindung lassen sich Schneidklemmverbindungen im Zuge von Fügeprozessen realisieren, die hochstrombelastbar sind und aufgrund nur einer geringen Anzahl von Übergängen (Kontaktierungen verschiedener Elemente) sehr niederohmig ausgebildet werden können.

Insbesondere ist vorgesehen, dass eine erfindungsgemäß gebildete Schneidklemmverbindung nach dem Fügeprozess mechanisch entkoppelt ausgebildet wird. Dies kann beispielsweise dadurch erfolgen, dass die Hochstromverbindungen nach dem Fügeprozess nicht mehr zugänglich sind, da sie in zu schließenden Gehäusen eingesetzt werden. Um das Zusammendrücken von Flachband-Verbindungen 5 und Gegen-Flachband-Verbindung 36 zu erleichtern, kann ein Schmierstoff oder eine gleitende Beschichtung auf die Schneidklemmverbindung aufgebracht werden. Die Schneidklemmverbindung wird bevorzugt in eine Tasche eingebracht, die beim Fügeprozess verschlossen wird. Damit ist ein Flitterschutz gegeben. Insbesondere ist die Flachband-Verbindung 5 aufgrund der Biegestelle 10 als bewegliches Element ausgebildet, das mit einem festen, unbeweglichen Gegenelement, insbesondere des Verbrauchers, durch Fügekraft verbunden wird. Alternativ kann auch derart vorgegangen werden, dass die Gegen-Flachband-Verbindung 36 beweglich ist und die Flachband-Verbindung 5 fest angeordnet wird.

## Patentansprüche

1. Leistungselektronikschaltung, die auf einem Substrat angeordnet und eine elektrische, hochstrombelastbare Verbindung die insbesondere direkt am Substrat an eine Anshluβstelle (4) angeschlossen ist, wobei die Verbindung (3) als Flachband-Verbindung (5) ausgebildet ist und im Bereich ihres freien Endes ein Schneidklemmverbindungselement (15) aufweist,
**dadurch gekennzeichnet, dass**
an dem freien Ende mindestens eine Stützschulter (17) als Auflager zu einem Gegenlager ausgebildet ist und eine Zusammenfügkraft beim Verbinden mit einem Gegenelement (22) gegen ein Einleiten in das Substrat abgestützt ist.

2. Leistungselektronikschaltung nach Anspruch 1, **dadurch gekennzeichnet, dass** die Flachband-Verbindung (5) als Metallstreifen, insbesondere Blechstanzteil, ausgebildet ist.

3. Leistungselektronikschaltung nach einem der vorhergehenden Ansprüche, **dadurch gekennzeichnet, dass** mindestens zwei, einander gegenüberliegende Stützschultern (17) vorgesehen sind.

4. Leistungselektronikschaltung nach einem der vorhergehenden Ansprüche, **dadurch gekennzeichnet, dass** der insbesondere direkte Anschluss der Verbindung (3) als Löt-, Schweiß- und/oder Nietverbindung ausgebildet ist.

5. Leistungselektronikschaltung nach einem der vorhergehenden Ansprüche, **dadurch gekennzeichnet, dass** die Flachband-Verbindung (5) in Richtung ihrer Längserstreckung durch die Ausbildung mindestens einer Biegestelle (10) verformbar ist, wobei die Biegestelle (10) insbesondere als U-Steg (11) oder als mäanderförmiges Element ausgebildet ist.

6. Leistungselektronikschaltung nach einem der vorhergehenden Ansprüche, **dadurch gekennzeichnet, dass** das Schneidklemmverbindungselement (15) als Einsteckschlitz (18) für einen Einstecksteg (21,24) des Gegenelements (22) oder als Einstecksteg (21,24) für einen Einsteckschlitz (18) des Gegenelements (22) ausgebildet ist.

7. Leistungselektronikvorrichtung mit einer Leistungselektronikschaltung nach einem oder mehreren der vorherigen Ansprüche, **gekennzeichnet durch** eine mit der Flachband-Verbindung (5) **durch** Zusammenfügen elektrisch verbundene Gegen-Flachband-Verbindung (36), wobei die Gegen-Flachband-Verbindung (36) das Gegenelement (22) aufweist oder bildet, und als Metallstreifen (6'), insbesondere als Blechstandsteil, ausgebildet ist.

8. Leistungselektronikvorrichtung nach einem der vorhergehenden Ansprüche, **gekennzeichnet durch** einen elektrisch nichtleitenden Lagerkanal (12), an den sich die Flachband-Verbindung (5) mit ihrer mindestens einen Stützschulter (17) abstützt.

9. Leistungselektronikvorrichtung nach einem der vorhergehenden Ansprüche, **dadurch gekennzeichnet, dass** die mit der Gegen-Flachband-Verbindung (36) zusammengefügte Flachband-Verbindung (5) zumindest im Bereich ihrer Verbindungsstelle eingehaust und/oder in nichtleitendes Material, insbesondere Kunststoff, eingebettet oder eingegossen oder umspritzt ist.

10. Leistungselektronikvorrichtung nach einem der vorhergehenden Ansprüche, **dadurch gekennzeichnet, dass** das Substrat als Leiterplatte, insbesondere als IMS (Insulated Metal Substrate)- oder DBC (Direct Bonded Copper)- Substrat ausgebildet ist.

## Claims

1. Power electronic circuit which is arranged on a substrate and has an electrical connection which can be subjected to high current loading and which is connected in particular directly on the substrate to a connecting location (4), and the connection (3) is embodied as a ribbon connection (5) and has an insulation displacement connection element (15) in the region of its free end,
**characterized in that**
at the free end at least one supporting shoulder (17) is embodied as a bearing with respect to a counterbearing and a joining-together force during connection to a mating element (22) is protected against an introduction into the substrate.

2. Power electronic circuit according to Claim 1, **characterized in that** the ribbon connection (5) is embodied as a metal strip in particular sheet-metal stamped part.

3. Power electronic circuit according to either of the preceding claims, **characterized in that** at least two supporting shoulders (17) lying opposite one another are provided.

4. Power electronic circuit according to any of the preceding claims, **characterized in that** the in particular direct connection of the connection (3) is embodied as a soldering, welding and/or riveting connection.

5. Power electronic circuit according to any of the preceding claims, **characterized in that** the ribbon connection (5) is deformable in the direction of its longitudinal extent by the formation of at least one bending location (10), wherein the bending location (10) is embodied in particular as a U-web (11) or as a meandering element.

6. Power electronic circuit according to any of the preceding claims, **characterized in that** the insulation displacement connection element (15) is embodied as an insertion slot (18) for an insertion web (21, 24) of the mating element (22) or as an insertion web (21, 24) for an insertion slot (18) of the mating element (22).

7. Power electronic device comprising a power electronic circuit according to one or more of the preceding claims, **characterized by** a mating ribbon connection (36) electrically connected to the ribbon connection (5) by joining together, wherein the mating ribbon connection (36) has or forms the mating element (22) and is embodied as a metal strip (6'), in particular as a sheet-metal stamped part.

8. Power electronic device according to any of the preceding claims, **characterized by** an electrically non-conductive bearing channel (12), on which the ribbon connection (5) is supported by its at least one supporting shoulder (17).

9. Power electronic device according to any of the preceding claims, **characterized in that** the ribbon connection (5) joined together with the mating ribbon connection (36), at least in the region of its connection location, is housed and/or embedded into or cast into or encapsulated by injection moulding with non-conductive material, in particular plastic.

10. Power electronic device according to any of the preceding claims, **characterized in that** the substrate is embodied as a printed circuit board, in particular as an IMS (Insulated Metal Substrate) or DBC (Direct Bonded Copper) substrate.

## Revendications

1. Circuit électronique de puissance, qui est disposé sur un substrat et qui présente une liaison électrique à forte capacité de courant, laquelle est notamment raccordée directement au substrat à un point de raccordement (4), la liaison (3) étant réalisée sous la forme d'une liaison en nappe (5) et présentant un élément de liaison à borne guillotine (15) dans la zone de son extrémité libre, **caractérisé en ce qu'**au moins un épaulement de soutien (17) faisant office d'appui pour une butée est formé à l'extrémité libre et une force d'assemblage y est soutenue pour empêcher son induction dans le substrat lors de la liaison avec un élément homologue (22).

2. Circuit électronique de puissance selon la revendication 1, **caractérisé en ce que** la liaison en nappe (5) est réalisée sous la forme de bandes métalliques, notamment d'une pièce découpée en tôle.

3. Circuit électronique de puissance selon l'une des revendications précédentes, **caractérisé en ce qu'**il existe au moins deux épaulements de soutien (17) opposés l'un à l'autre.

4. Circuit électronique de puissance selon l'une des revendications précédentes, **caractérisé en ce que** le raccordement notamment direct de la liaison (3) est réalisé sous la forme d'une liaison brasée, soudée et/ou rivetée.

5. Circuit électronique de puissance selon l'une des revendications précédentes, **caractérisé en ce que** la liaison e, nappe (5) est déformable dans le sens de sa projection longitudinale en formant au moins un point de flexion (10), le point de flexion (10) étant notamment réalisé sous la forme d'un profilé en U (11) ou sous la forme d'un élément en méandre.

6. Circuit électronique de puissance selon l'une des revendications précédentes, **caractérisé en ce que** l'élément de liaison à borne guillotine (15) est réalisé sous la forme d'une fente d'insertion (18) pour une nervure d'insertion (21, 24) de l'élément homologue (22) ou sous la forme d'une nervure d'insertion (21, 24) pour une fente d'insertion (18) de l'élément homologue (22).

7. Dispositif électronique de puissance comprenant un circuit électronique de puissance selon une ou plusieurs des revendications précédentes, **caractérisé par** une liaison en nappe homologue (36) reliée électriquement par assemblage avec la liaison en nappe (5), la liaison en nappe homologue (36) présentant ou formant l'élément homologue (22) et étant réalisée sous la forme de bandes métalliques (6'), notamment sous la forme d'une pièce découpée en tôle.

8. Dispositif électronique de puissance selon l'une des revendications précédentes, **caractérisé par** un conduit support (12) non conducteur d'électricité sur lequel s'appuie la liaison en nappe (5) avec son au moins un épaulement de soutien (17).

9. Dispositif électronique de puissance selon l'une des revendications précédentes, **caractérisé en ce que** la liaison en nappe (5) assemblée avec la liaison en nappe homologue (36) est logée et/ou noyée ou surmoulée ou enrobée dans un matériau non conducteur, notamment une matière plastique, au moins dans la zone de son point de liaison.

10. Dispositif électronique de puissance selon l'une des revendications précédentes, **caractérisé en ce que** le substrat est réalisé sous la forme d'un circuit imprimé, notamment d'un substrat IMS (Insulated Metal Substrate - Substrat métallique isolé) ou DBC (Direct Bonded Copper - Cuivre en liaison directe).
